# EUROPEAN PATENT APPLICATION

(11) **EP 4 342 745 A1**
(43) Date of publication of application: **27.03.2024**
(21) Application number: 23198422.0
(22) Date of filing: 20.09.2023
(51) Int. Cl.: B60S 1/04, H02K 5/10, F16H 57/029, H02K 7/116, H05K 5/03

(54) **LID, CLOSED BOX BODY, TRANSMISSION UNIT FOR USE IN WIPER, AND WIPER**

(30) Priority: 20.09.2022 CN 202211141429
(71) Applicant: Bosch Automotive Products (Changsha) Co., Ltd., Changsha Hunan 410100 (CN)
(72) Inventor: Yu, Chunfu, Changsha, Hunan Province, 410100 (CN); QIN, Zonglian, Changsha, Hunan Province, 410100 (CN); Dai, Yu, Changsha, Hunan Province, 410100 (CN)
(74) Representative: Bee, Joachim

(57) **Abstract**

Disclosed in the present invention is a lid (2) for closing a cavity (1), comprising: a sealing structure (21) for sealingly engaging with an opening of the cavity; and a vent hole (22) that extends through the lid, when the interior space of the cavity can only be in fluid communication with the outside by means of the opening, the vent hole being used to maintain fluid communication between the interior space and the outside when the lid is sealingly engaged with the opening of the cavity; wherein the vent hole is configured to form a closing structure that closes the vent hole by hot melting the material of the region of the vent hole, and the lid is configured to at least restrict, during the closing of the vent hole by hot melting, the molten material that solidifies to form the closing structure from flowing toward the interior space along the vent hole. Also disclosed are a corresponding closed box body (3), a corresponding transmission unit (4) for use in a wiper, and a corresponding wiper. According to certain exemplary embodiments of the present invention, complete sealing of the vent hole can be ensured and undesirable flow of the molten material can be prevented.

## Description

### TECHNICAL FIELD

The present invention relates to a lid for closing a cavity, a corresponding closed box body, a corresponding transmission unit for use in a wiper, and a corresponding wiper.

### BACKGROUND

In industrial manufacturing, it is often necessary to close a cavity to prevent foreign substances from entering into the cavity and influencing the operation of components within the cavity or damaging the components within the cavity, particularly circuit devices.

In a wiper of a vehicle, a drive apparatus has a gearbox within which a transmission mechanism is provided so as to convert the power of a driver into the swing action of a wiper blade. Since the drive apparatus operates in the external environment, particularly in order to prevent water from entering the gearbox, the gearbox is generally closed by using a gearbox cover made of plastic, such that the gearbox is in a completely closed state.

When the gearbox is closed by using the gearbox cover, it is necessary to provide a vent hole in the gearbox cover so as to balance the internal and external pressure differential in an assembly process, avoiding an adverse effect on the sealing effect caused by the internal and external pressure differential after assembly being large. After the gearbox cover is closed on the gearbox, the vent hole is then closed by using a hot melting process (hot pressing), so as to complete the final closing operation. However, current vent holes are generally straight-through holes having a constant diameter. Such a vent hole may cause the plastic melted in the hot melting process to flow too quickly within the vent hole, thereby forming bubbles in the hardened material, which may cause the sealing structure to be less dense, causing a sealing failure. It may even cause the molten material to flow into the interior space of the cavity, causing damage to or failure of the components within the interior space.

Therefore, there is a need for continued improvement.

### SUMMARY

In view of the above insufficiencies and/or other possible shortcomings present in the prior art that are not mentioned herein, an improved lid for closing a cavity, a corresponding closed box body, a corresponding transmission unit for use in a wiper, and a corresponding wiper are provided.

According to a first aspect of the present invention, a lid for closing a cavity is provided, comprising: a sealing structure for sealingly engaging with an opening of the cavity; and a vent hole that extends through the lid, when the interior space of the cavity can only be in fluid communication with the outside by means of the opening, the vent hole being used to maintain fluid communication between the interior space of the cavity and the outside when the lid is sealingly engaged with the opening of the cavity; wherein the vent hole is configured to form a closing structure that closes the vent hole by hot melting the material of the region of the vent hole, and the lid is configured to at least restrict, during the closing of the vent hole by hot melting, the molten material for solidifying to form the closing structure from flowing toward the interior space along the vent hole.

According to a second aspect of the present invention, a closed box body is provided, the closed box body comprising the lid, wherein the lid is sealingly engaged with the cavity, and the vent hole is closed by hot melting.

According to a third aspect of the present invention, a transmission unit for use in a wiper is provided, the transmission unit comprising the closed box body and a transmission mechanism located within the closed box body.

According to a fourth aspect of the present invention, a wiper is provided, the wiper comprising the transmission unit and a drive unit transmissionally coupled to the transmission unit.

According to certain exemplary embodiments of the present invention, complete sealing of the vent hole can be ensured and undesirable flow of the molten material can be prevented.

### BRIEF DESCRIPTION OF THE DRAWINGS

The present invention will be described below in further detail with reference to the accompanying drawings, so that the principles, features, and advantages of the present invention can be better understood. The accompanying drawings include:
FIG. 1 shows a perspective view of a drive apparatus for a wiper according to an exemplary embodiment of the present invention.
FIG. 2 shows a perspective view of a gearbox cover of the drive apparatus shown in FIG. 1.
FIG. 3 shows a top view of the gearbox cover shown in FIG. 2.
FIG. 4 shows a cross-sectional view taken along line A-A in FIG. 3.
FIG. 5 shows the portion of circle B in FIG. 5 in an enlarged view.
FIG. 6 schematically shows a cross-sectional view of a vent hole of a gearbox cover according to an exemplary embodiment of the present invention.

### DETAILED DESCRIPTION

To enable the technical problems to be solved, the technical solutions, and the beneficial technical effects of the present invention to be clearer, the present invention will be described in further detail below with reference to the accompanying drawings and a plurality of exemplary embodiments. It should be understood that the specific embodiments described here are only used to explain the present invention, and are not used to limit the scope of protection of the present invention.

First, it should be noted that the application scenario of the present invention is mainly a wiper, and the following is also mainly described in view of a wiper, but those skilled in the art can understand that the technical idea of the present invention can also be applied to other application scenarios, particularly after reading the following description.

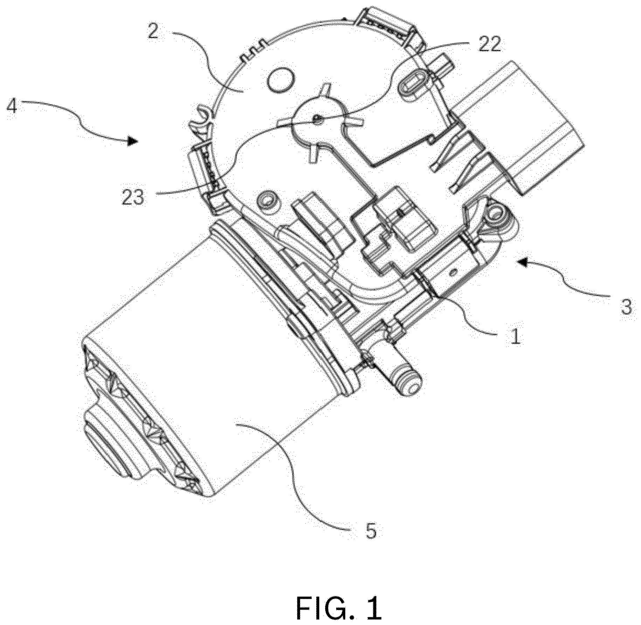

FIG. 1 shows a perspective view of a drive apparatus for a wiper according to an exemplary embodiment of the present invention.

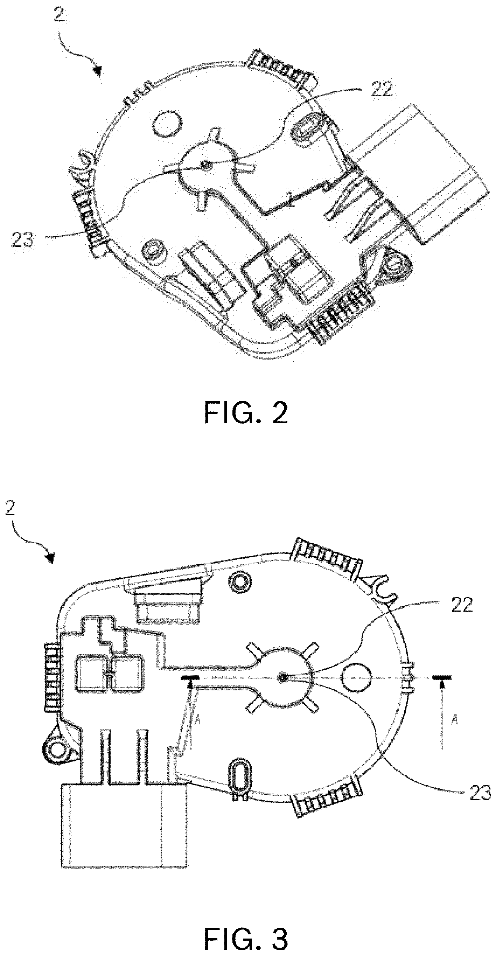

FIG. 2 shows a perspective view of a gearbox cover of the drive apparatus shown in FIG. 1.

FIG. 3 shows a top view of the gearbox cover shown in FIG. 2.

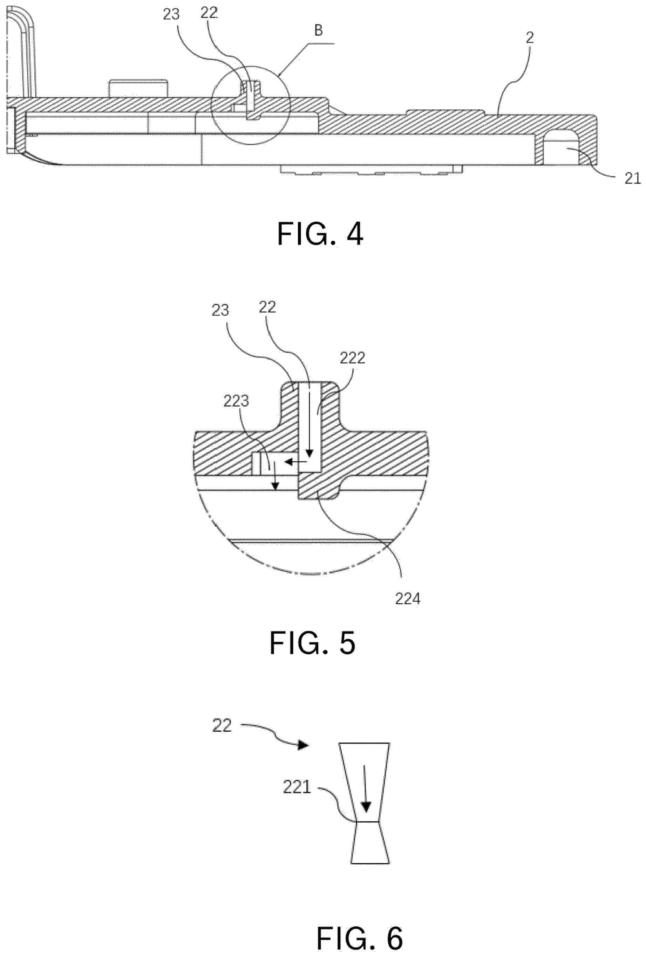

FIG. 4 shows a cross-sectional view taken along line A-A in FIG. 3.

FIG. 5 shows the portion of circle B in FIG. 5 in an enlarged view.

The gearbox cover is used to close a gearbox to prevent, when the gearbox is in use, water or other substances from entering into the gearbox. However, in order to embody the versatility of the present invention, the technical solution of the present invention is also generally described, but reference may still be made to FIGs. 1-5 for understanding.

In general, according to an exemplary embodiment of the present invention, a lid 2 for closing a cavity 1 is provided, comprising: a sealing structure 21 (see FIG. 4) for sealingly engaging with an opening of the cavity 1; and a vent hole 22 that extends through the lid 2, when the interior space of the cavity 1 can only be in fluid communication with the outside by means of the opening, the vent hole 22 being used to maintain fluid communication between the interior space of the cavity 1 and the outside when the lid 2 is sealing engaged with the opening of the cavity 1; wherein the vent hole 22 is configured to form a closing structure that closes the vent hole 22 by hot melting the material of the region of the vent hole 22, and the lid 2 is configured to at least restrict, during the closing of the vent hole 22 by hot melting, the molten material that solidifies to form the closing structure from flowing toward the interior space along the vent hole 22. The term "restrict" used herein is relative to the flow of the molten material when the vent hole is a straight-through hole having a constant diameter. By means of the restricting effect, a sufficient amount of molten material can be allowed to stay and solidify to form a reliable closing structure. It can be understood that, in any case, it is only required that the melted materials that are intended to close the vent hole 22 can reliably stay to form the closing structure. In practice, the materials melted in the hot melting process may not all be used for or participate in the formation of the closing structure or may not all be necessary to form the closing structure.

The sealing structure 21 may be any suitable structure, for example, is a groove as shown in FIG. 4. In this case, the lid 2 can be engaged onto the cavity 1 by filling an adhesive within the groove. The foregoing is not the focus of the present invention, and thus it will not be described again.

According to an exemplary embodiment of the present invention, the lid 2 is configured to obstruct the molten material from flowing out of the vent hole 22 toward the interior space along the vent hole 22. It can be understood by those skilled in the art that in an ideal state, the molten materials should preferably densely fill non-melted collapsed vent holes 22 without flowing out of the vent holes 22.

Further still, the lid 2 may be configured to obstruct any molten material produced during the closing of the vent hole 22 by hot melting from flowing out of the vent hole 22 toward the interior space along the vent hole 22. This means that any molten material flowing into a non-collapsed vent hole 22 will not flow out of a bottom portion (i.e., inner side) boundary of the vent hole 22, thereby on the one hand, ensuring that the molten material is used as much as possible to fill the non-melted collapsed vent hole 22, and on the other hand also preventing the molten material from dripping into the interior space and causing damage to or affecting the functions of components arranged within the interior space. For this reason, according to an exemplary embodiment of the present invention, the lid 2 is configured to prevent any molten material produced during the closing of the vent hole 22 by hot melting from dripping into the interior space along the vent hole 22. In order to be able to close the vent hole 22 by hot melting, at least the region around the vent hole 22 is required to be made of a hot-meltable material, such as a plastic. Preferably, the lid 2 is integrally injection-molded.

According to an exemplary embodiment of the present invention, and as shown in FIGs. 1-5, the outer side of the lid 2 (i.e., the side facing outward away from the interior space) is provided with a boss 23, and the vent hole 22 is at least partially formed in the boss 23. Preferably, the vent hole 22 is formed centrally in the boss 23.

The formation of the boss 23 may facilitate the implementation of the hot melting process because a hot melting head may selectively act on the boss 23 without damaging the surrounding structure. Also, the boss 23 can produce, during hot melting, sufficient molten material to close the vent hole 22. After closing by hot melting, the boss 23 will decrease in height and will not significantly protrude. Preferably, the boss 23 is generally cylindrical.

As shown in FIGs. 4 and 5, and according to an exemplary embodiment of the present invention, the vent hole 22 has a tortuous fluid path, which can be clearly seen, in particular, from a plurality of arrows in FIG. 5. The term "tortuous" is used primarily to distinguish from a straight hole, and therefore a "tortuous" hole also encompasses a continuously curved hole. In particular, a straight hole that is vertical (perpendicular to an extension plane of the lid 2, i.e., in a horizontal direction in FIG. 4) is likely to cause the molten material to drip directly under gravity without contacting a sidewall of the hole, or form a loose hanging pillar.

According to an exemplary embodiment of the present invention, and as shown in FIG. 5, the vent hole 22 has a first hole section 222 and a second hole section 223 that extends non-coaxially with and is in fluid communication with the first hole section 222, wherein the first hole section 222 leads to the outer side of the lid 2, and the second hole section 223 leads to an inner side of the lid 2.

While only two hole sections are shown in FIG. 5, it can be understood by those skilled in the art that it is not limited thereto in practice, for example, other hole sections or structures can be added between the two sections. The described curved flow path does not affect the pressure equilibrium of a gas passing through the vent hole 22, but may limit or affect the flow of viscous molten material. The tortuous path may be designed according to specific circumstances, for example, it is required to consider the difficulty of molding. Particularly in injection molding, in the design of the vent hole, it is required to consider the difficulty of molding more.

According to an exemplary embodiment of the present invention, and as shown in FIG. 5, the second hole section 223 is arranged laterally offset from the first hole section 222 (i.e., in an extension direction of the lid 2), such that the bottom portion of the first hole section 222 has a blocking structure 224. The blocking structure 224 may cause the molten material to build up thereon to prevent the same from continuing to flow down.

In particular, the first hole section 222 is arranged laterally side-by-side with and immediately adjacent to the second hole section 223, such that the first hole section 222 is laterally in direct fluid communication with the second hole section 223, as shown in FIG. 5. The second hole section 223 may have any suitable cross-sectional shape. It can be understood that the second hole section 223 is configured to be formed in a recessed portion on the inner side of the lid 2. The described recessed portion can be flexibly designed to accommodate the injection molding process of the lid 2.

It can be seen from FIG. 5 that the first hole section 222 has a generally constant diameter, and is preferably vertically arranged. In addition, as shown in FIG. 5, the blocking structure 224 may be configured as a protrusion located on the inner side of the lid 2.

It can be understood by those skilled in the art that the design of such a vent hole 22 may even simplify the injection molding process, particularly to reduce the number of sliding blocks used in the injection molding process, thereby reducing process costs.

The structure of the vent hole 22 shown in FIGs. 4 and 5 is better adapted to the injection molding process of the lid 2. However, it can be understood by those skilled in the art that the vent hole 22 is not limited thereto, and conversely, it is only required that the molten material for solidifying to form the closing structure is restricted from flowing toward the interior space along the vent hole 22.

FIG. 6 schematically shows a cross-sectional view of a vent hole 22 according to another exemplary embodiment of the present invention.

As shown in FIG. 6, the vent hole 22 is internally provided with a throttling structure 221. Here, the throttling structure 221 is configured to be a narrowing portion of the vent hole 22. It can be understood that the throttling structure 221 is not limited thereto, but may also be any other suitable structure, as long as the same can produce a throttling effect, and in particular has an effective throttling effect on viscous molten material.

According to an exemplary embodiment of the present invention, the vent hole 22 may be at least partially conically constructed. As shown in FIG. 6, vent hole sections on both sides of the throttling structure 221 are conically constructed. The upper vent hole section may be designed with a large upper opening and a small lower opening. The lower vent hole section may be inversely designed. Thus, the throttling structure 221 is formed.

Of course, the lower vent hole section may also be a straight hole section having generally the same diameter.

In the above, the working principle and example design of the lid 2, particularly the vent hole 22 of the lid 2, are described in connection with some exemplary embodiments, but those skilled in the art may also make adaptive modifications or adjustments under guidance of the ideas of the present invention.

As shown in FIG. 1, the present invention also relates to a closed box body 3. The closed box body 3 includes the lid 2 according to any one of the above exemplary embodiments, wherein the lid 2 is sealingly engaged with the cavity 1 and the vent hole 22 is closed by hot melting (not yet closed by hot melting in FIG. 1). The present invention does not limit the specific use and structure of the closed box body 2, but according to an exemplary embodiment of the present invention, the cavity 1 is a gearbox and the lid 2 is a gearbox cover.

As also shown in FIG. 1, the present invention also relates to a transmission unit 4 for use in a wiper. The transmission unit 4 includes the closed box body 3 according to any one of the above exemplary embodiments and a transmission mechanism (in an obscured state in FIG. 1), for example, a gear transmission mechanism, located within the closed box body 3.

In addition, as also shown in FIG. 1, the present invention also relates to a wiper, the wiper including the transmission unit 4 of any one of the above exemplary embodiments and a drive unit 5, for example, a motor, transmissionally coupled to the transmission unit 4. Other possible constituent parts of the wiper are not shown herein because they are not related to the inventive points of the present invention.

Although some embodiments have been illustrated, these embodiments are presented by way of example only, and are not intended to limit the scope of the present invention. The appended claims and their equivalents are intended to cover all modifications, substitutions, and alterations that fall within the scope and spirit of the present invention.

### LIST OF REFERENCE NUMBERS

- 1: Cavity
- 2: Lid
- 3: Closed box body
- 4: Transmission unit
- 5: Drive unit
- 21: Sealing structure
- 22: Vent hole
- 23: Boss
- 221: Throttling structure
- 222: First hole section
- 223: Second hole section
- 224: Blocking structure

## Claims

1. A lid (2) for closing a cavity (1), comprising:
a sealing structure (21) for sealingly engaging with an opening of the cavity (1); and
a vent hole (22) that extends through the lid (2), when the interior space of the cavity (1) can only be in fluid communication with the outside by means of the opening, the vent hole (22) being used to maintain fluid communication between the interior space of the cavity (1) and the outside when the lid (2) is sealingly engaged with the opening of the cavity (1);
wherein the vent hole (22) is configured to form a closing structure that closes the vent hole (22) by hot melting the material of the region of the vent hole (22), and the lid (2) is configured to at least restrict, during the closing of the vent hole (22) by hot melting, the molten material that solidifies to form the closing structure from flowing toward the interior space along the vent hole (22).

2. The lid (2) according to claim 1, wherein,
the lid (2) is configured to obstruct the molten material from flowing out of the vent hole (22) toward the interior space along the vent hole (22).

3. The lid (2) according to claim 1 or 2, wherein,
the lid (2) is configured to obstruct any molten material produced during the closing of the vent hole (22) by hot melting from flowing out of the vent hole (22) toward the interior space along the vent hole (22).

4. The lid (2) according to any one of claims 1-3, wherein,
the lid (2) is configured to prevent any molten material produced during the closing of the vent hole (22) by hot melting from dripping into the interior space along the vent hole (22).

5. The lid (2) according to any one of claims 1-4, wherein,
at least a region surrounding the vent hole (22) is made of a hot-meltable material; and/or the lid (2) is integrally injection-molded; and/or
the outer side of the lid (2) is provided with a boss (23), and the vent hole (22) is at least partially formed in the boss (23).

6. The lid (2) according to any one of claims 1-5, wherein,
the vent hole (22) has a tortuous fluid path; and/or
the vent hole (22) is internally provided with a throttling structure (221).

7. The lid (2) according to claim 6, wherein,
the vent hole (22) has a first hole section (222) and a second hole section (223) that extends non-coaxially with and is in fluid communication with the first hole section (222), the first hole section (222) leading to the outer side of the lid (2), and the second hole section (223) leading to the inner side of the lid (2); and/or
the vent hole (22) has a narrowing part.

8. The lid (2) according to claim 7, wherein,
the second hole section (223) is arranged laterally offset from the first hole section (222), such that the bottom portion of the first hole section (222) has a blocking structure (224); and/or
the vent hole (22) is at least partially conically constructed.

9. The lid (2) according to claim 8, wherein,
the first hole section (222) is arranged laterally side-by-side with and immediately adjacent to the second hole section (223), such that the first hole section (222) is laterally in direct fluid communication with the second hole section (223); and/or
the first hole section (222) has a generally constant diameter; and/or
the second hole section (223) is configured to be formed in a recessed portion on the inner side of the lid (2); and/or
the blocking structure (224) is configured as a protrusion located on the inner side of the lid (2).

10. A closed box body (3), the closed box body (3) comprising the lid (2) according to any one of claims 1-9, wherein the lid (2) is sealingly engaged with the cavity (1), and the vent hole (22) is closed by hot melting.

11. The closed box body (3) according to claim 10, wherein,
the cavity (1) is a gearbox, and the lid (2) is a gearbox cover.

12. A transmission unit (4) for use in a wiper, the transmission unit (4) comprising the closed box body (3) according to claim 10 or 11 and a transmission mechanism located within the closed box body (3).

13. A wiper, the wiper comprising the transmission unit (4) according to claim 12 and a drive unit (5) transmissionally coupled to the transmission unit (4).
